# FASCICULE DE BREVET EUROPEEN

(11) **EP 1 087 652 B1**
(45) Date de publication et mention de la délivrance du brevet: **26.07.2006**
(21) Numéro de dépôt: 00402504.5
(22) Date de dépôt: 12.09.2000
(51) Int. Cl.: H05K 7/20

(54) **Perfectionnements aux assemblages électroniques à drain thermique, notamment pour module de commande de lampe à décharge de projecteur de véhicule automobile**
Verbesserungen für gekühlte elektronische Baugruppen, insbesondere für Steuerungsmodul eines Kraftfahrzeugscheinwerfers
Improvements in cooled electrical assemblies, especially for a control module for a discharge head lamp of a vehicle

(30) Priorité: 22.09.1999 FR 9911828
(43) Date de publication de la demande: 28.03.2001
(73) Titulaire: VALEO VISION, 93012 Bobigny Cédex (FR)
(72) Inventeur: Prajescu, Adrian, 93012 Bobigny Cedex (FR); Duarte, Marc, 93012 Bobigny Cedex (FR); Nicolai, Jean-Marc, 93012 Bobigny Cedex (FR)

(56) Documents cités:
- EP-A- 0 291 400
- EP-A- 0 489 958
- DE-A- 19 532 992
- US-A- 4 974 119
- PATENT ABSTRACTS OF JAPAN vol. 1996, no. 06, 28 juin 1996 (1996-06-28) & JP 08 056086 A (FUJITSU TEN LTD), 27 février 1996 (1996-02-27)
- PATENT ABSTRACTS OF JAPAN vol. 015, no. 419 (E-1126), 24 octobre 1991 (1991-10-24) & JP 03 175698 A (MITSUBISHI ELECTRIC CORP), 30 juillet 1991 (1991-07-30)

## Description

La présente invention est relative aux assemblages électroniques à drain thermique.

Elle trouve en particulier avantageusement application pour des modules de commande de lampe à décharge de projecteur de véhicule automobile.

Des structures d'assemblages à drain thermique pour modules de commande de lampes à décharge de projecteurs de véhicule automobile ont déjà décrites, notamment dans les demandes de brevet FR 95 14.647 et FR 98 12.219

Les assemblages décrits dans ces demandes de brevet comportent une semelle métallique, qui constitue un drain thermique, et une carte à circuit imprimé qui est assemblée par exemple par collage sur ladite semelle.

Les couches utilisées pour réaliser le collage ne permettent pas nécessairement un bon transfert thermique entre la carte à circuit imprimé et la semelle.

Un but de l'invention est de proposer une structure d'assemblage qui permette d'améliorer les échanges thermiques entre la carte à circuit imprimé et la semelle, tout en étant d'un montage simple et d'un faible coût.

L'invention propose quant à elle un assemblage comportant une semelle métallique formant un drain thermique, ainsi qu'une carte à circuit imprimé portée par ladite semelle, caractérisé en ce que la semelle comporte au moins deux portées qui sont légèrement en saillie par rapport au reste de ladite semelle et sur lesquelles la carte à circuit imprimé est en appui, lesdites portées comportant au moins un pied de sertissage qui coopère avec un orifice complémentaires que présente la carte à circuit imprimé, pour fixer la carte à circuit imprimé sur la semelle et en ce qu'une couche d'un matériau thermiquement conducteur et électriquement isolant est disposée dans les zones entre les portées en étant interposée entre ladite carte et ladite semelle, la carte à circuit imprimé et la semelle exerçant une contrainte de compression sur le matériau thermiquement conducteur et électriquement isolant.

Avec une telle structure d'assemblage, le matériau interposé entre la carte à circuit imprimé et la semelle est parfaitement en contact avec ladite carte et ladite semelle et assure un excellent transfert thermique entre les deux.

La présence des portées évite que le matériau thermiquement conducteur et électriquement isolant de la couche soit écrasé à la fixation et permet d'éviter tout contact électrique entre la carte et la semelle, tout en conservant à ce matériau ses propriétés thermiquement conductrices et électriquement isolantes.

Avantageusement, la carte à circuit imprimé présente au moins un via thermique dans lequel est reçu le matériau thermiquement conducteur et électriquement isolant, sur lequel la carte à circuit imprimé et la semelle exercent une contrainte de compression.

La présence d'un ou plusieurs vias thermiques dans lesquels le matériau thermiquement conducteur et électriquement isolant de la couche flue et contribue à améliorer encore les échanges thermiques.

L'assemblage selon l'invention est en outre avantageusement complété par les différentes caractéristiques suivantes prises seules ou selon toutes leurs combinaisons techniquement possibles :
- les moyens de fixation que présentent une portée comprennent au moins un picot de sertissage qui coopère avec un orifice complémentaire de la carte à circuit imprimé ;
- un orifice de sertissage de la carte à circuit imprimé présente une métallisation en contact avec le picot de sertissage ; cette métallisation assure une reprise de masse entre la semelle et la carte à circuit imprimé; elle assure en outre un raidissement de la carte à circuit imprimé dans le zone de sertissage ;
- la semelle comporte au moins une contre forme pour recevoir au moins une partie d'un élément qui s'étend en saillie à partir de la carte à circuit imprimé, vers la semelle ;
- la semelle porte, au droit d'une portée, des ailettes de refroidissement qui s'étendent en saillie par rapport à la face de ladite semelle qui est opposée à la carte à circuit imprimé ;
- l'assemblage comporte un capot de blindage rapporté sur la semelle pour coiffer la carte à circuit imprimé et la couche de matériau thermiquement conducteur et éléctriquement isolant ;
- il comporte une cloison métallique de séparation et la carte à circuit imprimé porte d'un côté de cette cloison métallique de séparation une electronique de commande qui comprend notamment un microprocesseur et de l'autre côté de cette cloison une électronique de puissance ;
- la cloison métallique de séparation se prolonge à travers la carte à circuit imprimé jusqu'à la semelle métallique afin de définir avec celle-ci et le capot de blindage deux caissons isolés l'un de l'autre notamment des perturbations électromagnétiques.

L'invention propose en outre un module de commande pour lampe à décharge de projecteur de véhicule automobile, caractérisé en ce qu'il comporte un assemblage du type précité.

D'autres caractéristiques et avantages de l'invention ressortiront encore de la description qui suit. Cette description est purement illustrative et non limitative. Elle doit être lue en regard des dessins annexés sur lesquels :
- les figures 1 et 2 représentent schématiquement en coupe un assemblage conforme à un mode de réalisation possible de l'invention, avant et après sertissage ;
- les figures 3a et 3b illustrent l'opération de sertissage de la carte de l'assemblage des figures 1 et 2 sur la semelle dudit assemblage ;
- les figures 4a à 4c illustrent les différentes formes de poinçon qui peuvent être utilisées pour conformer les picots ;
- les figures 5 et 6 sont des représentations similaires à celles des figures 1 et 2, illustrant un autre mode de réalisation possible de l'invention ;
- la figure 7 est une représentation schématique en vue de dessus illustrant un détail de l'assemblage des figures 5 et 6 ;
- la figure 8 est une représentation schématique en vue en coupe partielle illustrant un autre mode de réalisation possible pour l'invention ;
- la figure 9 est une représentation schématique en coupe d'un mode de réalisation possible pour une semelle d'un assemblage conforme à l'invention ;
- les figures 10 et 11 sont des représentations schématiques en coupe illustrant la disposition des éléments de blindage sur un assemblage conforme à un mode de réalisation possible de l'invention ;
- la figure 12 est une représentation schématique en coupe partielle illustrant le montage d'un assemblage conforme à un mode de réalisation de l'invention dans un projecteur.

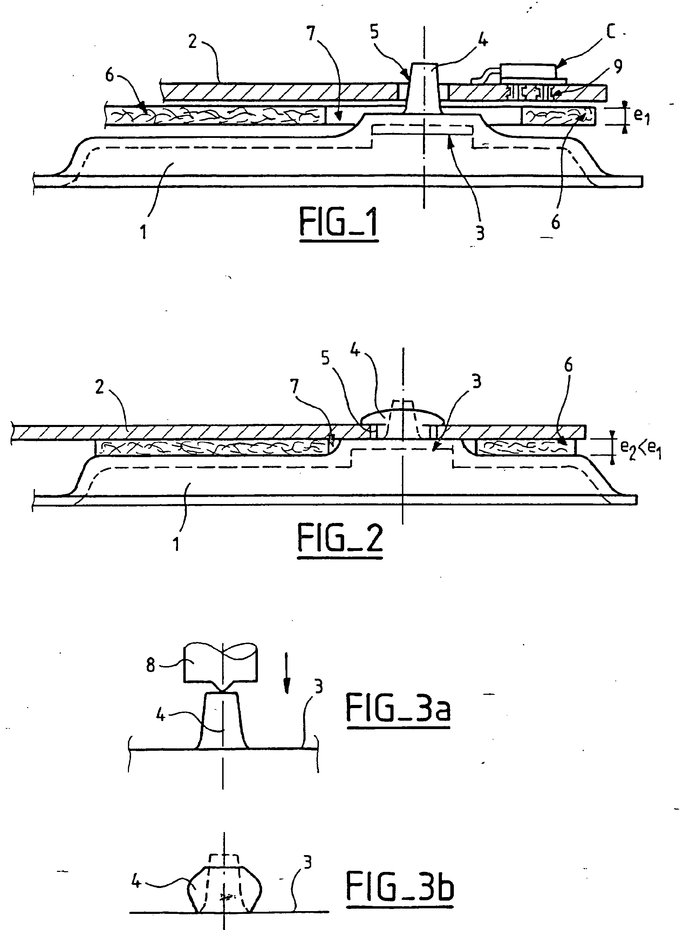

L'assemblage qui est représenté sur les figures 1 et 2 comporte une semelle métallique 1, qui constitue un drain thermique, ainsi qu'une carte à circuit imprimé 2 qui est montée sur ladite semelle 1 et qui porte un ou plusieurs composants C à montage en surface (composants CMS), ainsi qu'éventuellement un microprocesseur (non représenté sur les figures 1 et 2).

Cette semelle métallique 1 est par exemple en aluminium.

Elle est de forme générale plane et présente au moins deux portées 3 qui sont légèrement en saillie par rapport au reste de ladite semelle 1 et sur lesquelles la carte à circuit imprimé 2 vient en appui.

Elle peut être réalisée par emboutissage ou encore par moulage sous pression.

Ces portées 3 présentent elles-mêmes un ou plusieurs picots 4 qui s'étendent en saillie par rapport auxdites portées 3.

Les picots 4 que présente une portée 3 sont des picots de sertissage, qui traversent la carte 2 au niveau d'orifices complémentaires 5 que ladite carte 2 présente. Ils assurent en outre la reprise de masse.

Une couche 6 en un matériau électriquement isolant et thermiquement conducteur est interposée entre la carte 2 et la semelle 1.

Cette couche 6 s'étend dans les zones entre les portées 3. Les évidements qu'elle présente à cet effet au niveau des portées 3 ont été référencés par 7 sur les figures 1 et 2.

A titre d'exemple, ladite couche 6 peut être réalisée en un gel silicone renforcé par une trame de fibres de verre.

Le montage de l'assemblage qui vient d'être décrit peut s'effectuer de la façon suivante.

On place la couche 6 sur la semelle 1 en positionnant les évidements 7 de cette couche 6 sur les portées 3.

Puis on place la carte électronique à circuit imprimé 2 sur la semelle 1 et la couche 6 en présentant le ou les orifices 5 sur le ou les picots 4.

La carte 2 étant en appui sur les portées 3, on réalise son sertissage en écrasant le ou les picots 4 au moyen d'un outil 8 (figure 3a).

Le ou les picots 4 se déforment alors, ainsi qu'illustré sur la figure 3b, pour remplir le ou les orifices 5.

La carte 2 se retrouve alors totalement fixée sur la semelle 1.

Ladite carte 2 est empêchée de bouger perpendiculairement au plan selon lequel elle s'étend par la tête du ou des picots 4, qui est écrasée sur la face de la carte 2 opposée à la semelle 1.

En outre, la matière du ou des picots 4 qui remplit le ou les orifices 5 empêche la carte 2 de bouger dans des directions parallèles au plan selon lequel elle s'étend. Elle contribue à empêcher ladite carte 2 de bouger perpendiculairement audit plan.

Par ailleurs, la contrainte que réalise le sertissage au moyen du ou des picots 4 comprime la couche 6 en un matériau thermiquement conducteur.

Ladite couche 6 est en effet, avant montage, d'une épaisseur légèrement supérieure à la hauteur entre les portées 3 et le reste de la semelle 1.

La compression de la couche 6 favorise le transfert des calories entre la carte 2 et la semelle 1, les portées 3 assurant toutefois une épaisseur minimum pour ladite couche 6 de sorte que celle-ci conserve ses propriétés thermiquement conductrices et électriquement isolantes, malgré la compression.

Sur les figures 1 et 2, l'épaisseur de la couche 6 avant sertissage a été référencée par e1, son épaisseur après sertissage ayant été référencée par e2. La hauteur entre les portées 3 et le reste de la semelle 1 a été quant à elle référencée par e3. Comme on l'aura compris, e3 correspond à la valeur minimale que peut prendre l'épaisseur e2.

Pour favoriser le transfert thermique, la carte 2 peut être traversée, au droit des composants C, par des orifices 9 recouverts d'un dépôt en cuivre (« vias » cuivrés).

Lors du montage, la matière de la couche 6 flue dans lesdits orifices 9. La matière qui se trouve ainsi dans lesdits orifices ou vias 9 contribue à un meilleur comportement thermique de l'assemblage.

On notera que la forme que l'on donne aux picots peut varier selon la fonction ou l'orientation que l'on souhaite leur donner. Ainsi, certaines formes de picots sont plus propices à la reprise de masse et d'autres sont plus propices au maintien.

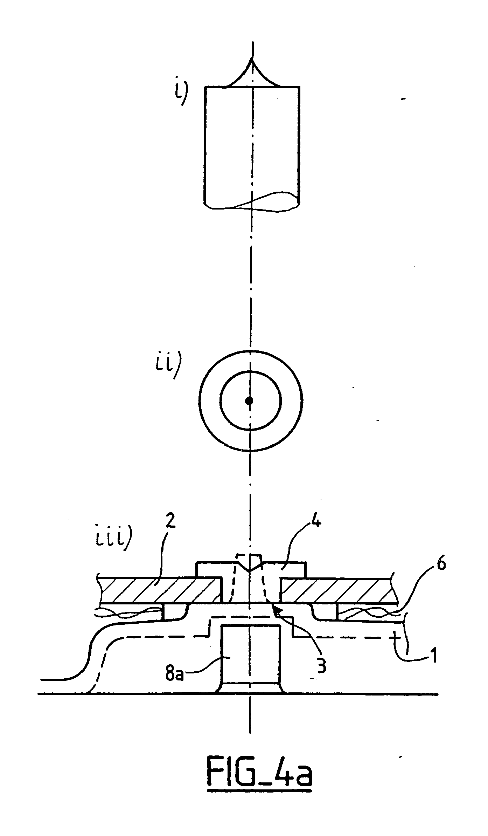

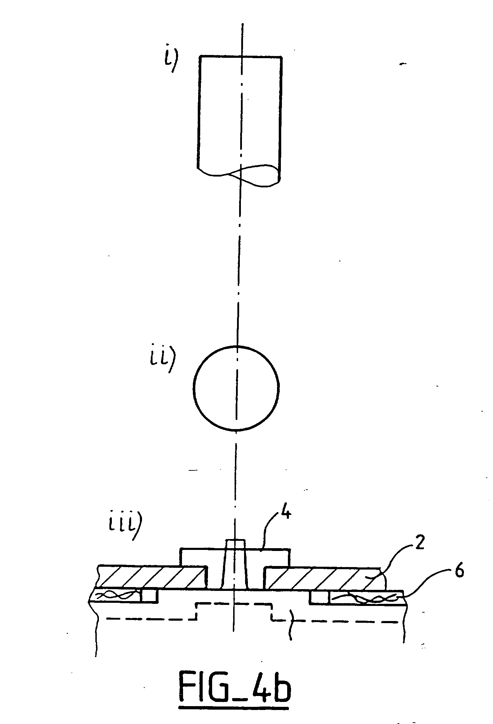

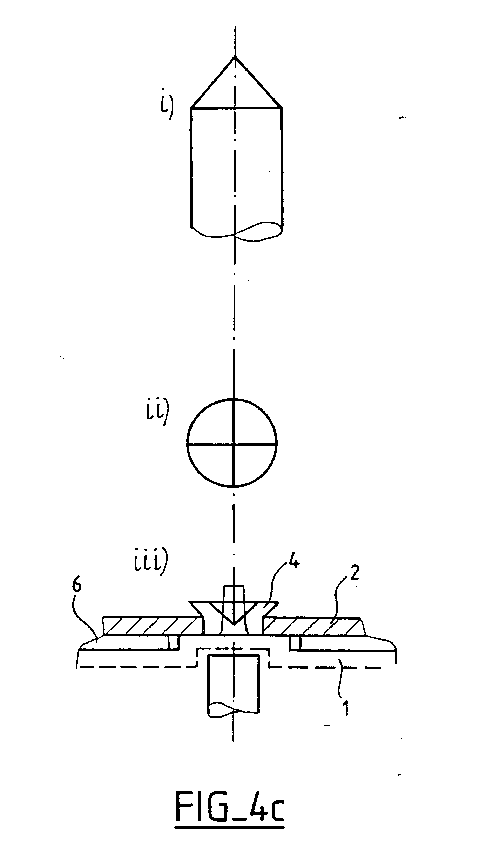

Les figures 4a, 4b et 4c illustrent différentes formes qui peuvent être envisagées pour le poinçon 8. Notamment, celui-ci peut être de type en pointe (figure 4a), de type plat (figure 4b) ou encore en pyramide (figure 4c), selon la forme que l'on veut donner à la tête du picot 4. Sur la figure 4a, iii), on a également représenté une enclume d'appui 8a, sur laquelle la semelle 1 est posée et qui sert à empêcher la déformation de ladite semelle 1 lorsque le poinçon 8 vient écraser le picot 4.

Par ailleurs, il peut être prévu sur les portées 3 des plots ou pions de centrage (non représentés sur les figures) disposés à proximité des picots 4 pour éviter le déplacement de la carte 2 lors du sertissage.

Ainsi, les picots ou pions que présente une portée 3 assurent trois fonctions : le sertissage, la reprise de masse, le centrage, un même pion ou picot pouvant assurer plusieurs de ces fonctions.

En outre, il peut être prévu sur la semelle 1 des picots de sertissage en d'autres endroits qu'au niveau des portées 3, notamment à proximité des connecteurs et des composants lourds portés par la carte 2, de façon à limiter les vibrations de la carte et à réduire les contraintes lors du montage/démontage des connecteurs.

Bien entendu, le procédé de montage qui vient d'être décrit ne se veut aucunement limitatif. En particulier, différents éléments peuvent être pré-assemblés.

Par exemple, la carte à circuit imprimé 2 et la couche 6 peuvent être pré-assemblées, avant l'équipement de ladite carte 2 en composants. Egalement, la couche 6 peut être pé-assemblée sur la semelle 1.

D'autres variantes que celles des figures 1 et 2 peuvent bien entendu être envisagées.

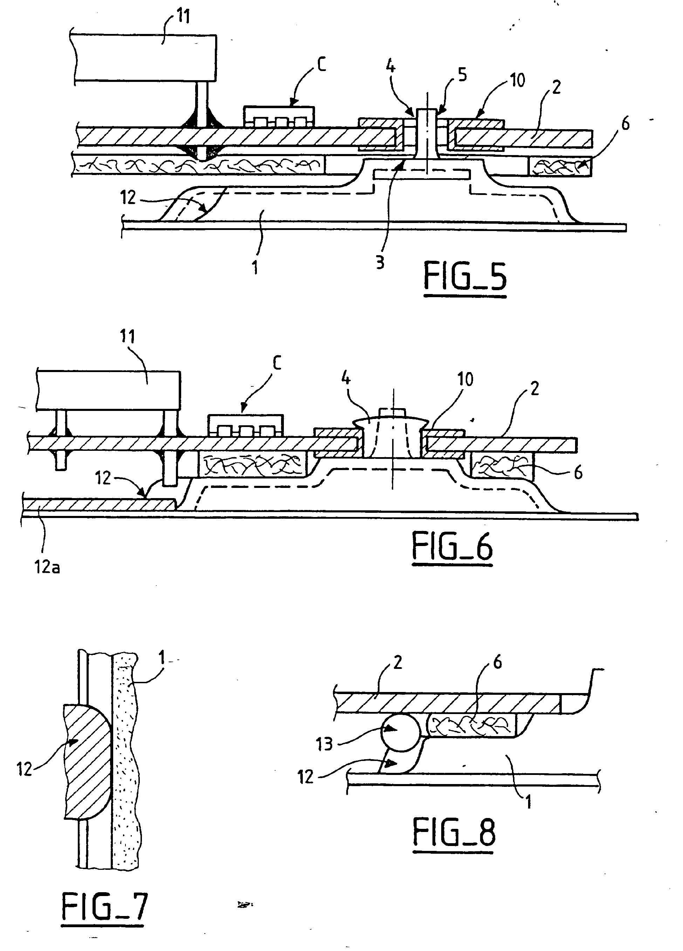

En particulier, ainsi qu'illustré sur les figures 5 à 7, les orifices de sertissage 5 peuvent être renforcés par une couche 10 s'étendant dans lesdits orifices et sur les bords de ceux-ci. Ce renfort 10 peut être isolant ou conducteur. Dans le cas où il est conducteur, il peut être utilisé pour assurer une reprise de masse entre la semelle métallique 1 et la face de la carte à circuit imprimé 2 qui est opposée à ladite semelle 1. Il est alors par exemple constitué par une métallisation en cuivre.

En outre, la carte à circuit imprimé 2 peut recevoir d'autres composants que des composants à montage de surface et notamment des composants traversants 11.

On prévoit alors avantageusement sur la semelle 1, au droit des composants traversants 11, des contre formes 12 permettant de dégager un volume pour recevoir les pattes de ces composants traversants 11.

Comme l'illustre la figure 6, en prévoit alors avantageusement une couche 12a qui s'étend sur la semelle 1 au droit des pattes des composants 11 et qui permet d'éviter des claquages entre lesdites pattes et ladite semelle 1 (lesdites pattes et ladite semelle sont en effet à des potentiels différents) .

En variante encore, on peut également envisager, ainsi qu'illustré sur la figure 8, que la carte à circuit imprimé 2 soit une carte double faces recevant un ou plusieurs composants CMS 13 brasés sur sa face directement en regard de la semelle 1.

La semelle 1 présente alors avantageusement une contre forme 12 au droit dudit composant 13.

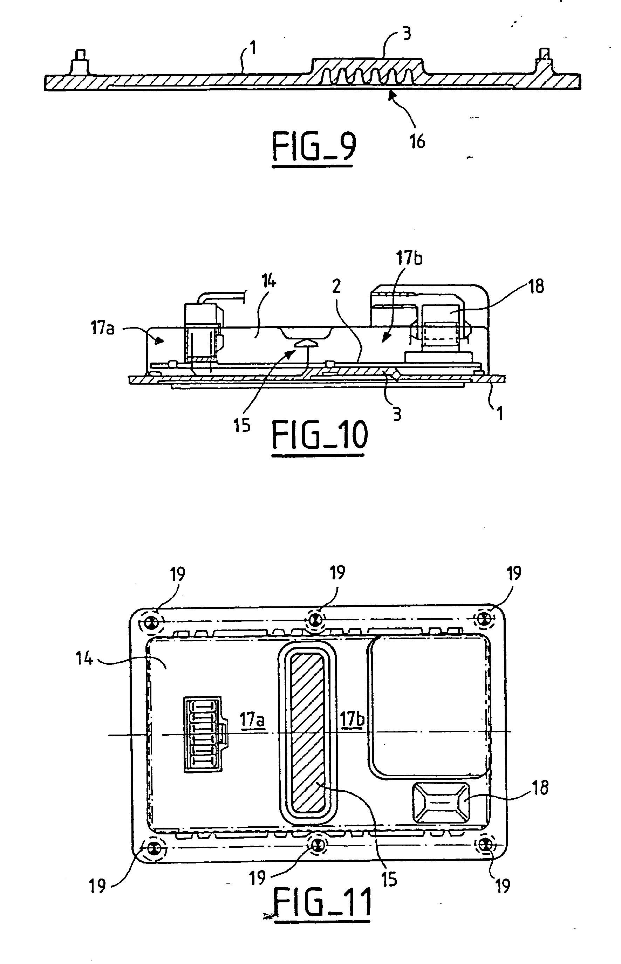

En variante encore, ainsi qu'illustré sur la figure 9, la semelle 1 peut présenter des ailettes de refroidissement 16 s'étendant au droit des portées 3, en saillie par rapport à la face de la semelle 1 qui est opposée à la carte 2 à circuit imprimé.

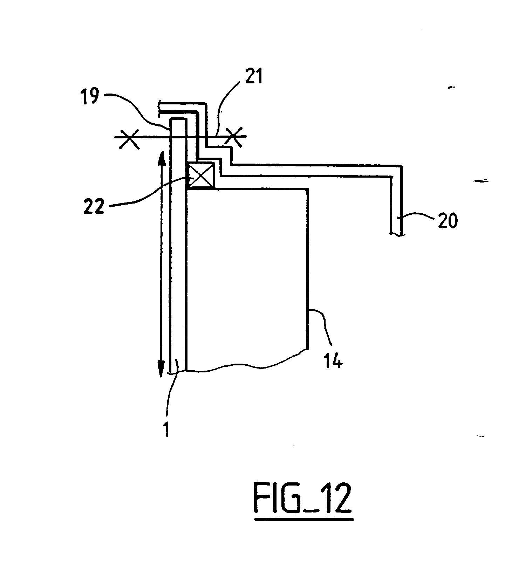

On a illustré sur les figures 10 et 11 un assemblage du type de ceux décrits en référence aux figures 1 à 7, complété par des éléments de blindage.

Ces éléments de blindage comportent en particulier un capot de blindage 14 qui est rapporté sur la semelle 1 et qui coiffe la carte (2) à circuit imprimé et la couche 6 de materiau thermiquement conducteur et électriquement isolant.

Ils comportent en outre une cloison métallique de séparation 15 rapportée sur la carte 2 pour isoler deux zones de celle-ci.

Cette cloison métallique de séparation 15 s'étend sur sensiblement toute la largeur de ladite carte 2.

Elle présente une embase par laquelle elle est portée par la carte 2 et est en contact électrique avec au moins une piste de masse de ladite carte. Elle est en outre en contact avec le capot de blindage 14 par sa partie opposée à ladite embase. La partie du capot de blindage 14 qui est en contact avec ladite cloison 15 est une partie emboutie dudit capot de blindage 14.

Une cloison de ce type a par exemple déjà été décrite dans la demande de brevet FR 98 12.219 à laquelle on se reportera avantageusement.

La carte à circuit imprimé 2 peut être une carte à plusieurs couches, comportant un plan de masse qui est relié à la cloison métallique de séparation 15 ou à une piste de masse que présente ladite carte

Les deux parties 17a, 17b délimitées par la cloison métallique de séparation 15 sur la carte 2 portent l'une des composants de puissance du module de commande, l'autre des composants de commande et notamment un microprocesseur de gestion.

La partie qui porte les composants de puissance est reliée, par l'intermédiaire d'un câble blindé 18 articulé sur le capot de blindage 14, à la lampe à décharge ou à d'autres moyens de puissance qui alimentent celle-ci.

La cloison métallique de séparation 15 se prolonge à travers la carte à circuit imprimé 2 jusqu'à la semelle métallique 1 pour définir avec celle-ci et le capot de blindage 14 deux caissons isolés l'un de l'autre des perturbations électromagnétiques qu'ils engendrent. Ainsi, on dispose de deux boîtes de blindage 17a, 17b séparées.

Les signaux passant de l'une de ces paries 17a, 17b à l'autre peuvent être filtrés au niveau de la cloison métallique de séparation 15 par des moyens de filtrage prévus à cet effet (capacité, filtre Rc...).

Une reprise de masse est assurée entre le capot de blindage 14 et ledit câble blindé 18, par exemple par une partie métallique élastique interposée entre les deux ou encore par une patte élastique que présente le capot de blindage 14. Cette reprise de blindage assure la continuité électrique entre le module de commande et la lampe à décharge.

Dans l'exemple illustré sur les figures 10 et 11, le capot de blindage 14 est fixé sur la semelle 1 par sertissage. On pourra à cet égard avantageusement se référer à la demande de brevet FR 98-02.478.

On notera qu'un des avantages de la technique qui vient d'être décrite tient en ce qu'elle ne nécessite pas de trous de fixation sur la semelle 1, de sorte que l'assemblage défini par ladite semelle 1 et le capot de blindage 14 est étanche.

Cette caractéristique rend l'assemblage particulièrement adapté à son utilisation pour un module de commande de lampe à décharge de projecteur de véhicule automobile.

La semelle 1 peut comporter à cet effet sur ses bords une pluralité de trous, référencés par 19 sur les figures 11 et 12, permettant sa fixation dans un ensemble projecteur.

Sur la figure 12, on a illustré un montage comportant un assemblage conforme à ceux qui viennent d'être décrits fixé par des vis 21 sur un boîtier 20 de projecteur. Un joint d'étanchéité 22 porté par la semelle 1 et entourant le capot de blindage 14 est interposé entre ledit boîtier 20 et l'assemblage.

La zone de l'assemblage qui est étanche est celle qui est illustrée par une double flèche sur la figure 12.

## Revendications

1. Assemblage comportant une semelle (1) métallique formant un drain thermique, ainsi qu'une carte (2) à circuit imprimé portée par ladite semelle (1), **caractérisé en ce que** la semelle (1) comporte au moins deux portées (3) qui sont légèrement en saillie par rapport au reste de ladite semelle (1) et sur lesquelles la carte (2) à circuit imprimé est en appui, lesdites portées (3) comportant au moins un picot de sertissage qui coopère avec un orifice (5) complémentaire que présente la carte (2) à circuit imprimé pour fixer la carte (2) à circuit imprimé sur la semelle (1) et **en ce qu'**une couche (6) d'un matériau thermiquement conducteur et électriquement isolant est disposée dans les zones entre les portées (3) en étant interposée entre ladite carte (2) et ladite semelle (1), la carte (2) à circuit imprimé et la semelle (1) exerçant une contrainte de compression sur la couche (6) de matériau conducteur et électriquement isolant.

2. Assemblage selon la revendication 1, **caractérisé en ce que** la carte (2) à circuit imprimé présente au moins un via thermique (9) dans lequel est reçu le matériau thermiquement conducteur et électriquement isolant de la couche (6).

3. Assemblage selon la revendication 2, **caractérisé en ce qu'**au moins un orifice de sertissage (5) de la carte (2) à circuit imprimé est renforcé par une couche (10) qui s'étend dans ledit orifice et sur les bords de celui-ci.

4. Assemblage selon la revendication 3, **caractérisé en ce que** ladite couche (10) est une couche de métallisation qui, par contact avec le picot de sertissage (4), assure une reprise de masse entre la semelle (1) et la carte (2) à circuit imprimé.

5. Assemblage selon l'une des revendications précédentes, **caractérisé en ce que** la semelle (1) comporte au moins une contre forme (12) pour recevoir au moins une partie d'un composant (13) qui s'étend en saillie à partir de la carte (2) à circuit imprimé, vers la semelle (1).

6. Assemblage selon l'une des revendications précédentes, **caractérisé en ce que** la semelle (1) porte, au droit d'une portée (3), des ailettes de refroidissement (16) qui s'étendent en saillie par rapport à la face de ladite semelle (1) qui est opposée à la carte (2) à circuit imprimé.

7. Assemblage selon l'une des revendications précédentes, **caractérisé en ce qu'**il comporte un capot de blindage (14) rapporté sur la semelle (1) pour coiffer la carte (2) à circuit imprimé et la couche (6) de matériau thermiquement conducteur et électriquement isolant.

8. Assemblage selon l'une des revendications précédentes, **caractérisé en ce qu'**il comporte une cloison métallique de séparation (15) et **en ce que** la carte (2) à circuit imprimé porte d'un côté de cette cloison métallique de séparation (15) une électronique de commande qui comprend notamment un microprocesseur et de l'autre côté de cette cloison métallique de séparation (15) une électronique de puissance.

9. Assemblage selon la revendication 9, **caractérisé en ce que** la cloison métallique de séparation (15) se prolonge à travers la carte à circuit imprimé jusqu'à la semelle métallique (1) afin de définir avec celle-ci et le capot de blindage (14) deux caissons isolés l'un de l'autre notamment des perturbations électromagnétiques.

10. Module de commande pour lampe à décharge de projecteur de véhicule automobile, **caractérisé en ce qu'**il comporte un assemblage selon l'une des revendications précédentes.

## Claims

1. Assembly comprising a metal base plate (1) forming a thermal drain, and a printed circuit card (2) carried by the said base plate (1), **characterised in that** base plate (1) comprises at least two surfaces (3) that project slightly with respect to the rest of the said base plate (1) and on which the printed circuit card (2) is in abutment, the said surfaces (3) comprising at least one crimping spike (4) that cooperates with a complementary orifice (5) that the printed circuit card (2) has for fixing the printed circuit card (2) to the base plate (1), and **in that** a layer (6) of a thermally conductive and electrically insulating material is disposed in the areas between the surfaces (3) whilst being interposed between the said card (2) and the said base plate (1), the printed circuit card (2) and the base plate (1) exerting a compression force on the layer (6) of thermally conductive and electrically insulating material.

2. Assembly according to claim 1, **characterised in that** the printed circuit card (2) has a least one thermal via (9) in which the thermally conductive and electrically insulating material of the layer (6) is received.

3. Assembly according to claim 2, **characterised in that** at least one crimping orifice (5) for the printed circuit card (2) is reinforced by a layer (10) that extends in the said orifice and on the edges thereof.

4. Assembly according to claim 3, **characterised in that** the said layer (10) is a metallisation layer that, by contact with the crimping spike (4), provides earthing between the base plate (1) and the printed circuit card (2).

5. Assembly according to one of the preceding claims, **characterised in that** the base plate (1) comprises at least one shape (12) for receiving at least part of a component (13) that extends projecting from the printed circuit card (2) towards the base plate (1).

6. Assembly according to one of the preceding claims, **characterised in that** the base plate (1) carries, in line with a surface (3), cooling fins (16) that extend projecting with respect to the face of the said base plate (1) that is opposite to the printed circuit card (2).

7. Assembly according to one of the preceding claims, **characterised in that** it comprises a shielding cap (14) attached to the base plate (1) in order to cover the printed circuit card (2) and the layer (6) of thermally conductive and electrically insulating material.

8. Assembly according to one of the preceding claims, **characterised in that** it comprises a metal separation partition (15) and **in that** the printed circuit card (2) carries, on one side of this metal separation partition (15), control electronics that comprise in particular a microprocessor and, on the other side of this metal separation partition (15), power electronics.

9. Assembly according to claim 9, **characterised in that** the metal separation partition (15) is extended through the printed circuit card as far as the metal base plate (1) in order to define with the latter and the shielding cap (14) two chambers isolated from each other in particular from electromagnetic interference.

10. Control module for a discharge lamp for a motor vehicle headlight, **characterised in that** comprises an assembly according to one of the preceding claims.

## Patentansprüche

1. Baugruppe mit einer eine Wärmesenke bildenden Metallplatte (1) sowie einer von der Metallplatte (1) getragenen Leiterplatte (2),
**dadurch gekennzeichnet, dass** die Metallplatte (1) wenigstens zwei Auflageflächen (3) aufweist, die bezüglich der restlichen Metallplatte (1) geringfügig vorstehen und auf denen die Leiterplatte (2) aufliegt, wobei die Auflageflächen (3) wenigstens einen Crimpstift (4) aufweisen, der mit einer komplementären Öffnung (5) zusammenwirkt, die die Leiterplatte (2) aufweist, um die Leiterplatte (2) auf der Metallplatte (1) zu befestigen, und dass eine Schicht (6) eines thermisch leitenden und elektrisch isolierenden Materials in den Bereichen zwischen den Auflageflächen (3) durch eingefügt sein zwischen der Leiterplatte (2) und der Metallplatte (1) angeordnet ist, wobei die Leiterplatte (2) und die Metallplatte (1) auf die Schicht (6) aus thermisch leitendem und elektrisch isolierendem Material eine Druckbeanspruchung ausüben.

2. Baugruppe nach Anspruch 1,
**dadurch gekennzeichnet, dass** die Leiterplatte (2) wenigstens einen thermischen Pfad (9) aufweist, in dem das thermisch leitende und elektrisch isolierende Material der Schicht (6) aufgenommen ist.

3. Baugruppe nach Anspruch 2,
**dadurch gekennzeichnet, dass** wenigstens eine Crimpöffnung (5) der Leiterplatte (2) durch eine Schicht (10) verstärkt ist, die in dieser Öffnung und auf deren Rändern verläuft.

4. Baugruppe nach Anspruch 3,
**dadurch gekennzeichnet, dass** die Schicht (10) eine Kontaktierungsschicht ist, die durch Kontakt mit dem Crimpstift (4) eine Masseverbindung zwischen der Metallplatte (1) und der Leiterplatte (2) gewährleistet.

5. Baugruppe nach einem der vorhergehenden Ansprüche,
**dadurch gekennzeichnet, dass** die Metallplatte (1) wenigstens eine Gegenform (12) aufweist, um wenigstens ein Teil eines Bauteils (13) aufzunehmen, das von der Leiterplatte (2) zur Metallplatte (1) vorstehend verläuft.

6. Baugruppe nach einem der vorhergehenden Ansprüche,
**dadurch gekennzeichnet, dass** die Metallplatte (1) rechtwinklig zu einer Auflagefläche (3) Kühlflügel (16) umfasst, die bezüglich der Seite der Metallplatte (1), die der Leiterplatte (2) gegenüberliegt, vorstehend verlaufen.

7. Baugruppe nach einem der vorhergehenden Ansprüche,
**dadurch gekennzeichnet, dass** sie eine Abschirmkappe (14) umfasst, die auf der Metallplatte (1) aufgesetzt ist, um die Leiterplatte (2) und die Schicht (6) aus thermisch leitendem und elektrisch isolierendem Material zu bedecken.

8. Baugruppe nach einem der vorhergehenden Ansprüche,
**dadurch gekennzeichnet, dass** sie eine Metalltrennwand (15) aufweist und die Leiterplatte (2) auf einer Seite der Metalltrennwand (15) eine Steuerelektronik mit insbesondere einem Mikroprozessor und auf der anderen Seite der Metalltrennwand (15) eine Leistungselektronik trägt.

9. Baugruppe nach Anspruch 8,
**dadurch gekennzeichnet, dass** sich die Metalltrennwand (15) durch die Leiterkarte hindurch bis zur Metallplatte (1) ausdehnt, um mit dieser und der Abschirmkappe (14) zwei Kammern zu bilden, die insbesondere vor elektromagnetischen Störungen voneinander isoliert sind.

10. Steuermodul für Kraftfahrzeug-Entladungslampe,
**dadurch gekennzeichnet, dass** es eine Baugruppe nach einem der vorhergehenden Ansprüche umfasst.
